# EUROPEAN PATENT SPECIFICATION

(11) **EP 0 577 187 B1**
(45) Date of publication and mention of the grant of the patent: **13.12.1995**
(21) Application number: 93201804.7
(22) Date of filing: 22.06.1993
(51) Int. Cl.: C03C 17/38, G03F 7/075

(54) **Method of providing a metal pattern on glass in an electroless process**
Verfahren zum Bilden eines Metallmusters auf Glas durch ein stromloses Verfahren
Méthode pour former un motif metallique sur verre par un procédé sans courant

(30) Priority: 29.06.1992 EP 92201925
(43) Date of publication of application: 05.01.1994
(73) Proprietor: Philips Electronics N.V., 5621 BA Eindhoven (NL)
(72) Inventor: Van der Putten, Andreas M. T. P., NL-5656 AA Eindhoven (NL); Willard, Nicolaas Petrus, NL-5656 AA Eindhoven (NL); Fokkink, Lambertus Gerrit Jan, NL-5656 AA Eindhoven (NL); Camps, Ivo Godfried Jozef, NL-5656 AA Eindhoven (NL)
(74) Representative: Stolk, Steven Adolph

(56) References cited:
- JOURNAL OF ELECTROCHEMICAL SOCIETY vol. 139, no. 6, June 1996, MANCHESTER, NH, US pages 1677 - 1680 , XP324420 J.M. CALVERT ET AL. 'Deep Ultraviolet Lithography of Monolayer Films with Selective Electroless Metallization'
- PATENT ABSTRACTS OF JAPAN vol. 11, no. 24 (C-399)23 January 1987 & JP-A-61 199071
- Database INSPEC, Institute of Electrical Engineers, London UK, INSPEC Nr. 3563411 & Chemtronics (UK) vol. 4, no. 3, September 1989, pages 202-208

## Description

The invention relates to a method of providing a metal pattern on a glass substrate in a electroless process, in which method the substrate is provided with a silane layer which is subsequently exposed to actinic radiation in accordance with a pattern, after which the substrate is brought into contact with a aqueous metal-salt solution, thereby forming the metal pattern on the unexposed areas of the substrate.

The invention relates in particular to a method of manufacturing a black matrix of metal on a passive plate of a liquid crystal display device.

Electroless or chemical metallization is a simple and inexpensive method of metallizing dielectric substrates such as glass and synthetic resins. For this purpose electroless metallization baths, such as copper and nickel baths, are used which comprise complexed metal ions and a reducing agent. On catalytic surfaces the metal ions are reduced to metal. In general, metallic Pd nuclei are provided on the surface to be metallized in order to render the surface catalytic. In a standard procedure the substrate to be metallized is nucleated beforehand (termed activation) by bringing the substrate into contact with either aqueous solutions of, in succession, SnCl₂ and PdCl₂ or with a colloidal SnPd dispersion. As a result thereof Pd nuclei are formed on the surface to be metallized. Subsequently, the activated surface is immersed in a electroless metallization bath, causing the surface to be metallized. Said activation methods are non-selective, *i.e*. the entire substrate surface, such as glass, is nucleated and hence metallized. These activation methods, in which the strongly reducing formaldehyde is used as the reducing agent, can suitably be used for electroless copper. However, for most electroless nickel baths said activation methods are less suitable due to the reduced reactivity of the reducing agents, for example hypophosphite, used in these baths. This is caused by adsorbed Sn⁴⁺ particles which are used as stabilizers in electroless nickel baths, but which also inhibit the oxidation of the reducing agent.

In electronic applications, selective or patterned metallization is often desired. This can be attained in various ways. In a subtractive process, first a uniform metal layer having the desired thickness is deposited on the substrate. Subsequently, a photoresist layer is provided which is exposed in accordance with a pattern and developed, thereby forming a pattern in the resist layer. Finally, the metal layer is etched selectively after which the resist layer is stripped off. In an additive process the substrate is activated with catalytic Pd nuclei. Subsequently, a photoresist layer is provided on the substrate, exposed in accordance with a pattern and developed, thereby forming a pattern in the resist layer. Subsequently, the surface is immersed in a electroless metallization bath, in which process metal is deposited in the desired thickness in the apertures of the resist pattern. Finally, the resist layer is stripped off and the Pd nuclei are removed by a short etching treatment. Both processes have the disadvantage that they require a relatively large number of process steps and involve the use of chemicals which are harmful to the environment, such as the resist stripper and the metal-etching bath. In addition, the provision of resist layers on large glass surfaces is no easy matter.

It is also known to apply a Pd-acetate film to a glass plate by means of spin coating, which film is locally decomposed to metallic palladium by means of a laser. The Pd acetate on the unexposed parts is subsequently removed. The pattern of Pd nuclei thus formed is then metallized in a electroless nickel or copper bath. The disadvantage of this method is the relatively large number of process steps and the high laser power necessary to decompose the Pd acetate. Consequently, the treatment of large glass surfaces is very time-consuming.

In United States Patent Specification US 4,996,075 a description is given of a method of depositing a very thin silver film in accordance with a pattern on a SiO₂ surface. In this method the surface is treated with a solution of a silane with a vinyl or acetylene group in a organic solvent such as carbon tetrachloride and chloroform. In this treatment a monomolecular silane layer is formed on the SiO₂ surface, *i.e*. a silane layer having a thickness equal to the length of the silane molecule is formed. Local irradiation of the silane layer with an electron beam causes the vinyl or acetylene groups to be chemically bonded to one another, thereby forming a polymer layer, and hence to be selectively deactivated. Subsequently, the surface is first immersed in a solution of diborane in THF and then in an alkaline solution of hydrogen peroxide, so that the unexposed vinyl groups are converted to hydroxyl groups. Subsequently the hydroxyl groups are converted to aldehyde groups. A treatment with an aqueous silver nitrate solution causes the silver ions to be reduced by the aldehyde groups to metallic silver, thereby forming a patterned silver layer having a thickness of one atom layer in the unexposed areas. A second monomolecular layer of vinyl silane can be formed on the silver oxide layer obtained by spontaneous conversion of the monoatomic silver layer to a monomolecular silver oxide layer, after which the above steps for converting vinyl groups *via* hydroxyl groups into aldehyde groups are repeated. Subsequently a second treatment with an aqueous silver nitrate solution is carried out, which results in the formation of a second monomolecular silver oxide layer. By repeating these steps may times an alternating laminate of monolayers of silane and monolayers of silver oxide is obtained.

A disadvantage of the known method is the large number of process steps required to obtain a metal pattern having of sufficient layer thickness, for example 0.1 »m or more, so that the layer is optically tight and/or has a sufficiently low electric resistance. Another disadvantage is the use of harmful organic solvents as a solvent for the silanes with a vinyl or acetylene group. A further disadvantage is formed by the fact that the proposed irradiation of the silane layer causes said layer to be deactivated by mutual bonding of the vinyl or acetylene groups, thereby forming a polymer layer which covers the SiO₂ surface. This polymer top layer cannot easily be removed and is often undesired. Due to said polymer layer the SiO₂ surface is inaccessible to other surface reactions or causes, for example, bonding problems with other layers to be provided.

It is an object of the invention to provide, *inter alia*, a method of providing a metal pattern on a glass substrate in an electroless process comprising relatively few process steps, and without using photoresist layers and organic solvents. A further object of the invention is to provide a method which can suitably be used for the patterned metallization of relatively large glass surfaces of, for example, 25 x 40 cm. A still further object of the invention is to provide a method which can suitably be used for an electroless nickel bath.

These objects are achieved by a method as described in the opening paragraph, which is characterized in that the silane layer is provided from a aqueous solution of silane and in that, during patterned irradiation, the silane layer is removed down to the substrate in the irradiated areas, after which the substrate is brought into contact with a Pd sol which is stabilized with a water-soluble polymer and, subsequently, the non-irradiated areas of the substrate are metallized in an electroless metallization bath, thereby forming the metal pattern. In this connection, the term "sol" is to be understood to mean a colloidal dispersion of Pd in water. The method is based on the observation that Pd particles which are stabilized with water-soluble polymers do not adsorb on glass surfaces, whereas on materials other than glass an excellent Pd coating is obtained. Surface modification of the glass surface by applying even monolayers of another material can influence the adsorption properties of the Pd nuclei. A glass surface can very suitably be modified by means of various silanes which form a chemical bond with the glass surface. Selective adsorption of Pd nuclei from polymer-stabilized Pd sols is attained by patterning the silane (mono)layer. The pattern in the silane layer is obtained by locally removing the silane layer by means of actinic radiation, for example using a ArF excimer laser, a oxygen plasma or a UV ozone treatment using a (shadow) mask or template. In places where the silane layer is removed, *i.e*. on the clean glass surface, no adsorption of Pd nuclei takes place, but at the silane layer adsorption of Pd nuclei does take place. The pattern of Pd nuclei is subsequently metallized in an electroless metallization bath, thereby forming the metal pattern. By means of said method a very high density of Pd nuclei of 2.10¹⁵ Pd atoms per cm² is obtained, which leads to a very good initiation of not only electroless copper baths but also all less reactive electroless nickel baths which are commercially available. The high density of Pd nuclei also brings about a very satisfactory adhesion of the copper or nickel layer as well as a high selectivity for the metallization of the unexposed places relative to the exposed places. In this connection, it is possible to substitute glass by quartz, quartz glass and glass ceramic such as Macor™. Also said latter materials are not activated by a polymer-stabilized Pd sol, but they are activated by the known SnPd sols ad by SnCl₂/PdCl₂ activation. Said Pd sol can be prepared by adding a suitable reducing agent, such as H₃PO₂ and dimethyl aminoborane, to an aqueous HCl-containing solution of a Pd salt, such as PdCl₂, Pd nitrate and Pd acetate, causing metallic Pd to be formed, said solution also comprising a water-soluble polymer which stabilizes the sol. Steric hindrance of the polymer chains on the Pd particles precludes flocculation of said particles.

Suitable, water-soluble polymers are polyvinyl alcohol (PVA) and polyvinyl pyrrolidone (PVP). In the case of PVA a heterodisperse sol is obtained having particles ranging from 2-10 nm. When PVP is used a monodisperse sol is formed having particles of 2 nm. A particle of 2 nm contains approximately 500 Pd atoms. The molecular weight and the polymer concentration are chosen to be such that per Pd particle one polymer chain is adsorbed at said particle. Preferably, PVP having an average molecular weight of approximately 10,000 is used (for example K-15 obtainable from Fluka). A relatively low average molecular weight in combination with said small particles brings about a high density of not only Pd nuclei on the substrate, resulting in an excellent initiation of the electroless metallization, but also nickel nuclei. Pd-PVP sols are more stable than Pd-PVA sols, so that the former sol has a longer life cycle. By virtue thereof a concentrated stock solution of a Pd-PVP sol can be prepared which is diluted, for example 10 x, before use. Another advantage of PVP relative to PVA is that the formation of foam in the nucleating solution is reduced.

In accordance with the invention, aqueous solutions of silane are used to avoid the use of undesirable organic solvents. Suitable silanes are water-soluble aminosilanes comprising at least one alkoxy group. Said silanes include those complying with the formula

R³NH(CH₂)₃SiR¹₂(OR²)

where
R¹ = CH₃, C₂H₅, methoxy or ethoxy and
R₂ = CH₃ or C₂H₅
R₃ = H, CH₃, C₂H₅ or (CH₂)ₘNHR⁴
R⁴ = H, CH₃ or C₂H₅ and
m = 1, 2 or 3.
Suitable representatives are 3-aminopropyl triethoxysilane and N-(2-aminoethyl)-3-aminopropyl trimethoxysilane. An example of a substance which can also suitably be used is 3-aminopropyl dimethylmethoxysilane. The concentration of the silane used in water is not critical and ranges, for example, between 0.1 and 3% by weight. The immersion time of the substrate in the silane solution is not critical either for the subsequent Pd adsorption. One of the alkoxy groups of the silane molecule reacts with a hydroxy group of the glass surface and brings about a chemical bond. Of course, prior to silanation, the glass surface must be cleaned to a sufficient degree.

The patterned removal of the silane layer is preferably effected by means of an UV-ozone treatment. A commercially available UV-ozone reactor comprises a low-pressure mercury discharge lamp generating two relevant wavelengths, namely 185nm and 254 nm. The UV light having a wavelength of 185 nm is absorbed by oxygen from the atmosphere and generates one which, subsequently, absorbs the 254 nm radiation thereby forming atomic oxygen. In said atmosphere it takes two minutes to completely remove the silane layer from the glass surface at a temperature of 25° C. A material which is inert under said conditions is used as the mask, for example a foil of stainless steel which is provided with apertures having the desired pattern. During the UV-ozone treatment the silanated glass surface is covered with said foil which is provided with apertures. In the exposed parts of the glass surface, which correspond to the apertures in the foil, the silane layer is removed down to the glass. In said parts no nucleation takes place in the subsequent activation treatment and said parts are not metallized. In principle, other methods of locally removing the silane layer can alternatively be used, for example a method employing an oxygen plasma and a mask or by means of local exposure using a laser light beam as generated by, for example, an ArF excimer laser (wavelength 198 nm).

As stated above, the number of Pd atoms adsorbed at the glass surface amounts to 2.10¹⁵ per cm² if the method in accordance with the invention is used. If Pd-PVA sols are used a density of 3.10¹⁵ Pd atoms per cm² is attained. Said values are determined by means of XRF (X-ray fluorescence). Such a surface has a very catalytic effect and leads to a reliable electroless metallization process, even in the case of less reactive electroless nickel baths. All known electroless nickel baths can be used, for example nickel baths on the basis of glycine, succinate, pyrophosphate and citrate. Use can also be made of the known commercially available baths, such as Shipley 65™, OMI Enplate 426™, Shipley Niposit 468™, Enlyte 512 and 514™. In addition to a nickel salt such a bath always comprises a reducing agent such as hypophosphite or dimethyl aminoborane. Frequently, stabilizers such as sulphur compounds or lead salts are present to preclude the spontaneous deposition of nickel.

The method in accordance with the invention is particularly suitable for the manufacture of a black matrix of metal on a passive plate of a liquid crystal display device (LCD), in particular for passive plates having relatively large dimensions of, for example, 25 x 40 cm. The black matrix improves the contrast between the three colour filters red, green and blue of the colour filter pattern. Generally, a thin chromium film is used for this purpose in which apertures are formed in a photolithographic process, *i.e*. providing the photoresist, exposing, developing, etching and stripping off the resist. Said apertures constitute the pixels of the passive plate of the LCD and have dimensions of for example 50 x 70 »m. In accordance with the invention, a cleaned glass plate is treated with an aqueous solution of a silane, thereby forming a (monomolecular) layer of silane on the glass plate. The treated glass plate is covered with a mask having apertures with dimensions equal to the dimensions of the pixels. In an UV-ozone reactor the silane layer is removed from the supporting plate at the location of the mask apertures. Subsequently, an activation treatment using a Pd sol which is stabilized with a water-soluble polymer takes place. Then the unexposed areas are nickel plated by means of an electroless nickel bath, thereby forming said black matrix. At a thickness of 0.1 »m, the nickel layer is optically tight.
The method in accordance with the invention is completely additive and, in addition, no use is made of photoresists and developers and etchants which are harmful to the environment. The colour filters are provided in the apertures by means of, for example, screen printing, ink-jet printing or lithographic techniques. After the colour filters are provided an equalizing layer and an ITO layer are successively provided. The method in accordance with the invention is also suitable for the manufacture of a black matrix of metal on face plates of other flat colour displays, such as flat cathode ray tubes.
The method in accordance with the invention is also suitable for the manufacture of metal electrodes on glass selection plates of an electron fiber display such as described in European patent appplication EP-A-400750.

Other applications of the method in accordance with the invention include the manufacture of conductor patterns for chin-glass and copper patterns for coils in minimotors.

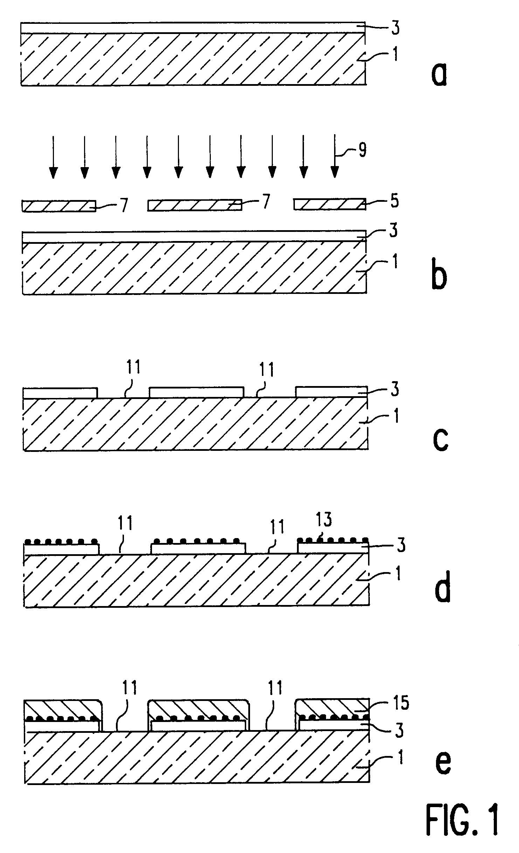

The invention will be explained in greater detail by means of an exemplary embodiment and with reference to a drawing in which Fig. 1 diagrammatically shows the process steps of the method in accordance with the invention.

### Exemplary embodiment

A polymer-stabilized Pd sol which can suitably be used in the method in accordance with the invention is prepared as follows. A quantity of 0.6 ml of a PdCl₂ solution consisting of 10 g/l of PdCl₂ and 350 ml/l of concentrated hydrochloric acid in water is diluted with 38,4 ml of water. A quantity of 0.07 ml of a 1 wt.% polyvinyl pyrrolidone (PVP) solution in water is added to this solution. Said PVP is obtained from Fluke, type K-15, and has an average molecular weight of 10,000. Subsequently 1 ml of a 0,625 molar H₃PO₂ solution is added while stirring. The Pd sol formed is monodisperse with particles of 2 nm and is used as an activating solution.

Fig. 1 diagrammatically shows the process steps of the method in accordance with the invention, the glass test substrate and the layers to be provided being diagrammatically shown in cross-section.

A borosilicate glass plate 1 (Fig. 1A) having dimensions of 35 x 35 mm is used as the test substrate. Said test substrate is cleaned with an aqueous solution comprising 20 g of sodium gluconate, 25 g of sodium hydroxide and 3 g of Tensagex™ (wetting agent) per litre.

After rinsing with demineralized water the test substrate is immersed in a 0.3 wt. % solution of 3-aminopropyl triethoxysilane (A0750 obtainable from Petrarch) in water for 1 minute. By the reaction of an ethoxy group of said silane with an -SiOH group of the glass surface a wane layer 3 having a thickness of approximately 1-5 nm is formed on the glass surface. The silane used comprises three reactive ethoxy groups, so that the silane layer consists of a three-dimensional network (polysiloxane). If two ethoxy groups of said silane are substituted by methyl groups (A0735 available from Petrarch) a monolayer of said silane is formed on the glass surface. The modified test substrate is rinsed with demineralized water and dried.

On the modified test substrate there is provided a mask 5 (Fig. 1B) consisting of a 100 »m thick foil of Invar™ (NiFe alloy comprising 36 wt.% of Ni), in which a pattern of circular holes 7 having a diameter of 100 »m and a pitch of 200 »m is etched. The test substrate which is covered with the mask is placed in an UV-ozone reactor (manufactured by Samco UV-1) at a temperature of 125° C for 5 minutes. The arrows 9 denote the UV radiation. In the UV-ozone treatment the silane layer is completely removed in the exposed areas 11 (Fig. 1C).

Subsequently, the test substrate is immersed in the above-mentioned activating solution of PVP-stabilized Pd sol for 4 minutes. Pd nuclei 13 are formed in the unexposed areas of the test substrate (Fig. 1D). Said nucleation is selective: in the exposed areas there are no Pd nuclei. Surface analysis using TEM (Transmission Electron Microscopy) shows that the Pd nuclei have a dimaeter of 2 nm. XRF analysis shows a degree of coverage of 2.10¹⁵ adsorbed Pd atoms per cm².

The activating treatment is followed by rinsing in demineralized water, after which the activated test substrate is introduced into an electroless nickel bath comprising 20 g of NiCl₂, 16 g of sodium succinate, 10 g of sodium hypophosphite and 2 g of sodium acetate per litre of water. The nickel bath is acidified with HCl to a pH-value of 4.5 and has a temperature of 70° C. After three minutes a nickel layer 15 (Fig. 1E) having a layer thickness of 0.2 »m is obtained in the unexposed areas of the test substrate. In the circular exposed areas 11 no nickel is formed. In this manner, a patterned nickel layer having circular apertures with a diameter of 100 »m which correspond to the pattern in the mask is formed on the glass test substrate. The adhesion of the nickel layer to the glass surface satisfies the requirements of the tape test.

In the same manner as described above a glass supporting plate, having dimensions of 25 x 40 cm, for an LCD is provided with a black matrix, a mask having apertures of 50 x 70 »m which correspond to the dimensions of the pixels being used. The nickel pattern formed on the supporting plate forms the black matrix.

The method in accordance with the invention comprises four fundamental process steps, namely silanating the glass surface, irradiating in accordance with a pattern, selectively activating with a stabilized Pd sol and electroless metallization in, for example, a nickel bath. This method enables a metal pattern to be provided on relatively large glass substrates in an electroless process comprising relatively few process steps and without using photoresists, developing liquids and organic solvents. Silanation and activation take place in aqueous solutions. A reliable electroless metallization process is obtained by virtue of the high density of the Pd nuclei attained during the activating treatment.

## Claims

1. A method of providing a metal pattern on a glass substrate in an electroless process, in which method the substrate is provided with a silane layer which is subsequently exposed to actinic radiation in accordance with a pattern, after which the substrate is brought into contact with an aqueous metal-salt solution, thereby forming the metal pattern on the unexposed areas of the substrate, characterized in that the silane layer is provided from an aqueous solution of silane and in that, during patterned irradiation, the silane layer is removed down to the substrate in the irradiated areas, after which the substrate is brought into contact with a Pd sol which is stabilized with a water-soluble polymer and, subsequently, the non-irradiated areas of the substrate are metallized in an electroless metallization bath, thereby forming the metal pattern.

2. A method as claimed in Claim 1, characterized in that the Pd sol is stabilized with a polymer selected from the group formed by polyvinyl alcohol and polyvinyl pyrrolidone.

3. A method as claimed in Claim 1, characterized in that an alkoxy aminosilane is used as the silane.

4. A method as claimed in Claim 3, characterized in that the silane is selected from the group formed by 3-aminopropyl triethoxysilane and N-(2-aminoethyl)-3-aminopropyl trimethoxysilane.

5. A method as claimed in Claim 1, characterized in that patterned irradiation takes place by an UV-ozone treatment and by using a mask on the substrate.

6. A method as claimed in Claim 1, characterized in that an electroless nickel bath is used as the metallization bath.

7. A method of manufacturing a black matrix of metal on a passive plate of a liquid crystal display device by using the method as claimed in Claim 1, patterned irradiation by an UV-ozone treatment being carried out while using a mask on the passive plate, said black matrix being formed by using an electroless nickel bath.

## Patentansprüche

1. Verfahren zum stromlosen Anbringen eines Metallmusters auf einem Glasträger, wobei der Träger mit einer Silanschicht versehen wird und wobei die Silanschicht daraufhin mustermäßig mit aktinischer Strahlung bestrahlt wird, wonach der Träger mit einer wässerigen Metallsalzlösung unter Bildung des Metallmusters auf nicht-bestrahlten Gebieten des Trägers in Berührung gebracht wird, dadurch gekennzeichnet, daß die Silanschicht aus einer wässerigen Lösung des Silans angebracht wird und daß bei der mustermäßigen Bestrahlung die Silanschicht in den bestrahlten Gebieten bis auf den Träger entfernt wird, wonach der Träger mit einem Pd-Sol in Berührung gebracht wird, das mit einem wasserlöslichen Polymer stabilisiert ist und daß daraufhin die nicht-bestrahlten Gebiete des Trägers unter Bildung des Metallmusters in einem stromlosen Metallisierungsbad metallisiert werden.

2. Verfahren nach Anspruch 1, dadurch gekennzeichnet, daß das Sol mit einem Polymer aus der durch Polyvinylalkohol und Polyvinylpyrrolidon gebildeten Gruppe stabilisiert ist.

3. Verfahren nach Anspruch 1, dadurch gekennzeichnet, daß als Silan ein Alkoxyaminosilan verwendet wird.

4. Verfahren nach Anspruch 3, dadurch gekennzeichnet, daß das Silan aus der durch Aminopropyltriäthoxysilan und N-(2-Aminoäthyl)-3-Aminopropyltrimethoxysilan gebildeten Gruppe selektiert worden ist.

5. Verfahren nach Anspruch 1, dadurch gekennzeichnet, daß die mustermäßige Bestrahlung durch eine UV-Ozonbehandlung und unter verwendung einer Maske auf dem Substrat durchgeführt wird.

6. Verfahren nach Anspruch 1, dadurch gekennzeichnet, daß als Metallisierungsbad ein stromloses Nickelbad verwendet wird.

7. Verfahren zum Herstellen einer schwarzen Matrix aus Metall auf einer passiven Platte einer Flüssig-Kristallwiedergabeanordnung unter Anwendung des Verfahrens nach Anspruch 1, wobei eine mustermäßige Bestrahlung durch eine UV-Ozonbehandlung unter Verwendung einer Maske auf der passiven Platte durchgeführt wird, wobei diese schwarze Matrix durch Verwendung eines stromlosen Nickelbades gebildet wird.

## Revendications

1. Procédé conçu pour former une configuration métallique sur un substrat en verte au moyen d'un processus sans courant, procédé suivant lequel le substrat est prévu d'une couche de silane exposée subséquemment à un rayonnement actinique conforme à une configuration, après quoi le substrat est mis en contact avec une solution aqueuse constituée de métal et de sel, de ce fait formant la configuration métallique sur les zones non exposées du substrat, caractérisé en ce que la couche de silane est formée à partir d'une solution aqueuse constituée de silane et en ce que, pendant le rayonnement mis en configuration, la couche de silane est enlevée jusqu'au substrat dans les zones rayonnées, après quoi le substrat est mis en contact avec un sol de Pd stabilisé par un polymère soluble dans l'eau et, subséquemment, en ce que les zones non rayonnées du substrat sont métallisées dans un bain de métallisation sans courant, de ce fait formant la configuration métallique.

2. Procédé selon la revendication 1, caractérisé en ce que le sol de Pd est stabilisé par un polymère choisi parmi le groupe formé par l'alcool polyvinylique et la pyrrolidone polyvinylique.

3. Procédé selon la revendication 1, caractérisé en ce qu'un aminosilane d'alcoxy est utilisé comme silane.

4. Procédé selon la revendication 3, caractérisé en ce que le silane est choisi parmi le groupe formé par le 3-aminopropyletriéthoxysilane et le N-(2-aminoéthyle)-3-aminopropyletriméthoxysilane.

5. Procédé selon la revendication 1, caractérisé en ce que le rayonnement mis en configuration se déroule par un traitement d'ozone à rayons ultraviolets et par l'utilisation d'un masque sur le substrat.

6. Procédé selon la revendication 1, caractérisé en ce qu'un bain de nickel sans courant est utilisé comme bain de métallisation.

7. Procédé conçu pour fabriquer une matrice noire à partir de métal sur une plaque passive d'un dispositif d'affichage à cristaux liquides par la mise en oeuvre du procédé selon la revendication 1, le rayonnement mis en configuration par un traitement d'ozone à rayons ultraviolets étant réalisé par l'utilisation d'un masque sur la plaque passive, ladite matrice noire étant formée par l'utilisation d'un bain de nickel sans courant.
